# EUROPEAN PATENT SPECIFICATION

(11) **EP 0 243 556 B1**
(45) Date of publication and mention of the grant of the patent: **09.06.1993**
(21) Application number: 86309285.4
(22) Date of filing: 27.11.1986
(51) Int. Cl.: C23C 14/34

(54) **Cathode/ground shield arrangement in a target for a sputter coating apparatus**
Kathode/Deckschirm-Anordnung in einem Target für einen Zerstäuber bei einem Beschichtungsapparat
Dispositif cathode/écran utilisé dans une cible pour un appareil pulvérisateur de revêtement

(30) Priority: 01.05.1986 US 858325
(43) Date of publication of application: 04.11.1987
(73) Proprietor: WESTINGHOUSE ELECTRIC CORPORATION, Pittsburgh Pennsylvania 15235 (US)
(72) Inventor: Glasser, Albert Daniel, Columbia South Carolina 29210 (US)
(74) Representative: van Berlyn, Ronald Gilbert

(56) References cited:
- EP-A- 0 166 256
- EP-A- 0 173 583
- DE-A- 3 404 880
- HANDBOOK OF THIN FILM TECHNOLOGY; Eds. L.I. Maissel and R. Glang, McGraw-Hill Book Company, 1970, page 4-13, Section 5a(1)
- Patent Abstracts of Japan, unexamined applications, C field, vol. 9, no. 293 Nov. 20 1985. The Patent Office Japanese Government page 64 C 315

## Description

The present invention relates generally to apparatus for depositing coatings on substrates and, more particularly, to a cathode/ground shield arrangement in a target of a sputter coating apparatus.

One field of use of sputter coating apparatus resides in the processing of nuclear fuel pellets. As well known in the nuclear reactor art, nuclear fuel pellets, commonly in the form of right circular cylinders, contain fissile material, such as uranium dioxide, thorium dioxide, plutonium dioxide or mixtures thereof. A stack of such pellets placed end-to-end within a cladding tube (typically made of a zirconium alloy or stainless steel) constitutes a fuel rod; an array of such fuel rods grouped together forms a fuel assembly; and a plurality of such fuel assemblies grouped together forms the core or a nuclear reactor.

Likewise as well known, the life of a nuclear fuel assembly can be extended by combining an initially larger amount of fissile material with a calculated smaller amount of a burnable neutron absorber, known in the art also as a burnable poison. Burnable neutron absorbers are materials, such as boron, gadolinium, samarium, europium, and the like, which have a high probability (or cross-section) for absorbing neutrons and which, in absorbing neutrons, result in isotopes of sufficiently low neutron capture cross-section to be virtually transparent to neutrons, all while producing no new or additional neutrons. Burnable absorbers thus compensate for the larger amount of fissile material during the early life of the fuel assembly and, during reactor operation, are progressively reduced in amount. This results in a longer life for the fuel assembly at relatively constant fission level which, in turn, means less frequent time-consuming and costly fuel assembly replacements, or reactor refueling operations.

In Applicant's U.S. patent specifications Nos. 4,587,088 and 4,560,462 there are disclosed a method and an apparatus, respectively, for sputter-depositing layers of burnable poisons on nuclear fuel pellets. Sputtering apparatus for depositing coatings on other kinds of products are disclosed in U.S. patent specifications No. 3,562,140, No. 3,632,494 and No. 4,080,281.

In a typical sputter process for depositing a coating on a substrate, such as a nuclear fuel pellet, an inert gas is introduced into a vacuum chamber containing an anode, the substrate, and a target cathode. A high voltage is applied across the anode and the target cathode. The gas molecules are ionized and strike the target cathode, thereby causing atoms and/or molecules of the latter to be sputtered from the surface thereof. The substrate is positioned to intercept this sputtered target material which, upon striking the substrate, forms thereon an adherent coating. Sputtering is generally a line-of-sight coating process.

In the apparatus disclosed in Applicant's aforesaid U.S. patent specification No. 4,560,462, several targets are employed each of which includes a cathode with target material in the form of generally rectangular tiles of zirconium diboride disposed on an upper surface thereof. The cathode is usually made of copper with magnetic material disposed inside to concentrate electrons in the vicinity of the cathode. This concentration enhances the generation of argon ions which collide with the negatively charged target material on the top surface of the cathode. The remaining surfaces of the cathode must be protected from the argon ions in order to prevent sputtering of the material of the cathode itself. Therefore, these remaining cathode surfaces are shielded by means of a ground shield which is positively charged and, therefore, collects electrons while repelling the argon ions. The ground shield and the cathode are separated from each other by a gap defined therebetween, the gap being wide enough normally to prevent electrical arcing thereacross yet small enough to prevent a plasma from starting because the electrons will have insufficient energy to ionize the argon.

A problem was encountered in the use of such targets which was discovered to be due to outgassing from the porous target tiles and the nuclear fuel pellets being coated. It was found that such outgassing can provide conditions of abnormally high relative humidity in the sputter coating facility which, in turn can cause shorting of the cathode and arcing across the gap between it and the ground shield. The arcs thus formed were also found to be so severe at times as to cause penetration of water cooling channels in the ground shield and, hence, water leaks.

From 'Handbook of Thin Film Technology'; Eds. Maissel and Glang, McGraw-Hill, 1970, page 4-13, it is known that insulating material may be used to suppress sputtering instead of a ground shield.

It is the principal object of the invention to alleviate these problems, and the invention accordingly consists in a sputter-coating-apparatus target comprising a cathode having an outer surface (66) with sputter target material disposed thereon, and a ground shield associated with the cathode and so disposed in spaced relationship with respect thereto as to define therebetween a gap which separates the cathode and the ground shield from one another, characterized in that: said gap (96) is completely filled with an electrical insulating material (102); and said cathode has mounted on a peripheral edge portion (66) of said outer surface (60) thereof means (90) forming a continuous peripheral ledge (94) which extends outwardly beyond said peripheral edge portion (66) and overhangs said gap (96) and the adjacent edges (86) of the ground shield (84) in spaced relationship therewith.

The insulating material, filling the gap so completely as to leave no perceptible space or void, will prevent dielectric breakdown and arcing across the gap even under conditions of high relative humidity. Preferably, the insulating material is ceramic insulation, such as aluminium oxide.

Where the mouth or entrance to the gap between the cathode and the ground shield is exposed to loose flakes of sputtered material falling onto the cathode, short-circuiting between the cathode and the ground shield can still occur if any such flakes bridge the gap. If this happens, it becomes necessary to temporarily shut down the coating apparatus and to clean out the offending flake or flakes of sputtered material, which results in significant expense and loss of time.

Therefore, and in order to avoid this problem, the target embodying the invention includes the above said means mounted on the said peripheral edge portion of the outer cathode surface bearing the sputter target material, and forming the said continuous peripheral ledge.

With this arrangement, the overhanging ledge will prevent loose flakes of sputtered material from bridging the gap and, hence, from shorting the cathode to the ground shield; any such loose flakes falling on the cathode will harmlessly land on it and/or on the overhanging ledge, either to be resputtered or eventually to fall to the floor of the facility.

A preferred embodiment of the invention will now be described, by way of example only, with reference to the accompanying drawings, in which:
Fig. 1 is a schematic view of a sputter coating apparatus;
Fig. 2 is a schematic view showing the sputter coating apparatus with its drum withdrawn from a chamber;
Fig. 3 is a fragmentary perspective front view of a lower portion of the open chamber of the apparatus, as seen when looking into the drum and showing two stationary lower targets;
Fig. 4 is a perspective rear view of the drum showing two stationary upper targets;
Fig. 5 is a schematic sectional view taken along line 5-5 of Fig. 1 and showing pellet-containing pallets on the drum, together with stationary lower and upper targets;
Fig. 6 is a top plan detail view, with portions broken away, of one of the pallets shown in Fig. 5;
Fig. 7 is an enlarged top plan view of a stationary target of an earlier design as utilized heretofore, wherein the entrance to the gap between cathode and ground shield is exposed to loose flakes of sputtered material falling upon the target;
Fig. 8 is a vertical longitudinal sectional view taken along line 8-8 of Fig. 7;
Fig. 9 is a fragmentary top plan view of a stationary target embodying the invention, including an overhanging ledge;
Fig. 10 is a fragmentary side elevational view as seen along the line 10-10 of Fig. 9;
Fig. 11 is a top plan view of the ground shield of the target of Figs. 9 and 10 but shown on a smaller scale; and
Fig. 12 is a vertical longitudinal sectional view of the ground shield, as taken along line 12-12 of Fig. 11.

In the following description, like reference characters designate like or corresponding parts throughout the several views of the drawings, and terms such as "forward", "rearward", "left", "right", "upwardly", "downwardly" and the like are employed as words of convenience not to be construed as limiting terms.

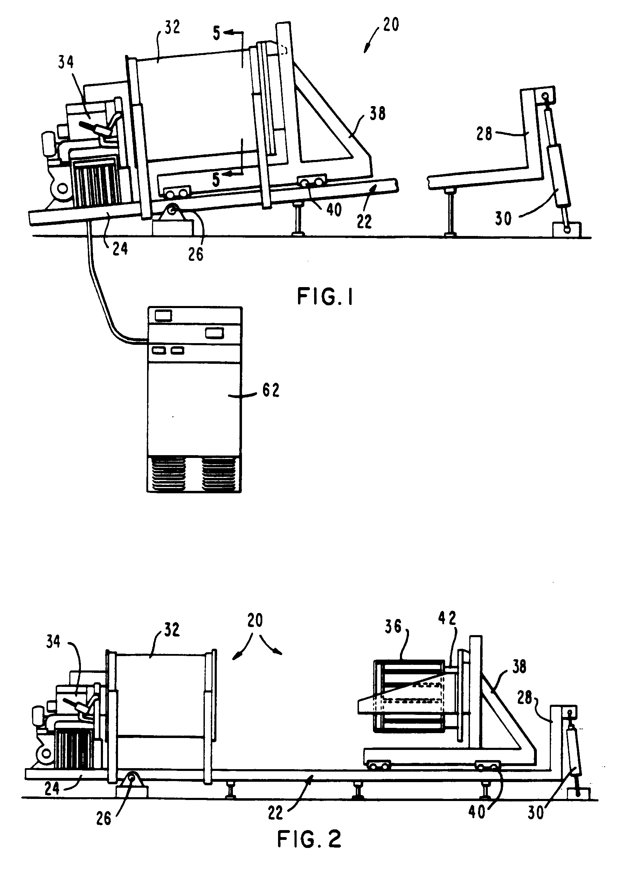

Referring to the drawings, and particularly to Fig. 1 thereof, the sputter coating apparatus illustrated therein and generally designated with reference numeral 20 is substantially the same as described and illustrated in Applicant's above-mentioned U.S. patent specification No. 4,560,462. It will be described herein but briefly in order to facilitate a complete understanding of the present invention.

Basically, the sputter coating apparatus 20 includes a frame 22 which is pivotally mounted near one end 24 on a hinge 26 and is supported, at its opposite end 28 and at locations spaced along its longitudinal extent, by extendible and retractable cylinders 30. The apparatus 20 includes further a sputtering chamber 32 and a sputter machine 34 operatively associated therewith, both being stationarily mounted on the frame 22 at its one end 24.

In addition, the apparatus 20 includes a drum 36 mounted on a support carriage 38 having rollers 40 for facilitating fore-and-aft movement of the drum 36 toward and away from the stationary sputtering chamber 32 between the positions shown in Figs. 1 and 2. Movement of the carriage 38 together with the drum 36 is caused by tilting of the frame 22 above the hinge 26 through actuation of the cylinder 30 connected to the end 28 of the frame opposite from the hinge 26. The drum 36 is mounted on the carriage 38 also for rotation above its longitudinal axis. A motor 42 likewise supported on the carriage 38 is coupled to the drum 36 and is operable to rotate same. The drum 36, when inserted in the sputtering chamber 32 (see Fig. 1), forms therewith a hermetic seal.

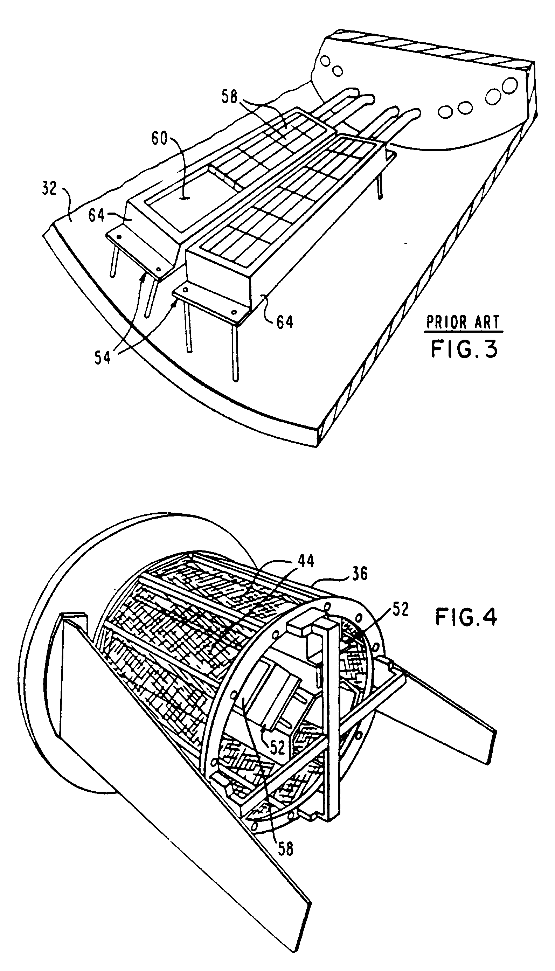

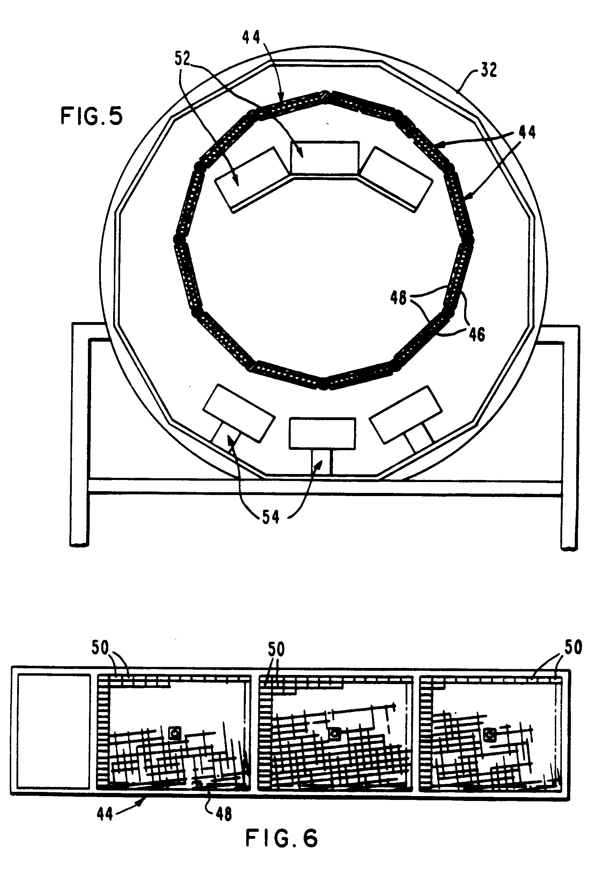

Mounted about the circumference of the drum 36 are detachable pallets 44 (Figs. 4 and 5) each of which comprises lower and upper screened parts 46,48 and contains a single layer of nuclear fuel pellets 50 to be coated, the pellets being aligned end-to-end in columns and rows (see Fig. 6). The sputter machine 34 has stationary upper and lower targets 52,54 mounted within the sputtering chamber 32, as seen from Figs. 3 to 5. Each of the targets 52,54 includes a cathode 56 with target tiles 58 disposed on an upper surface 60 thereof. The material of the tiles 58, preferably zirconium diboride, is sputtered as a coating onto the nuclear fuel pellets 50 as the pallets 44 containing the latter are rotating past the targets together with the drum 36. A control console 62 is used to control the drum motor 42 and the sputter machine 34. The drum 36 is made an anode for the sputter machine.

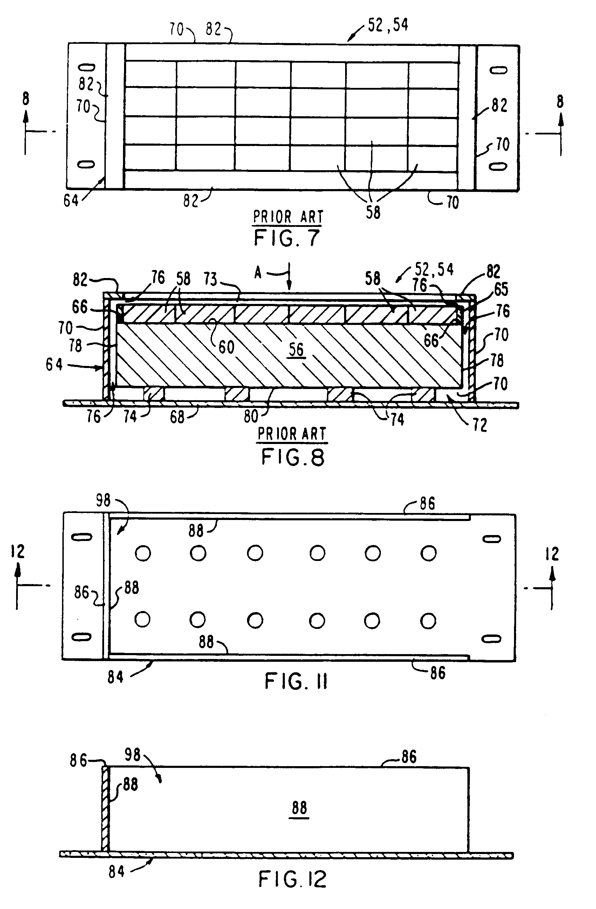

Referring to Figs. 7 and 8 which show a target such as previously utilized in the kind of sputter coating apparatus 20 illustrated herein, this target basically comprises a cathode 56, a plurality of target tiles 58, and a ground shield 64. The cathode 56 is of elongate, generally rectangular shape and is made of an electrically conductive material. The target tiles 58, formed of sputter frangible material, such as zirconium diboride, are disposed on the upper surface 60 of the cathode as a layer retained in position by a retainer 65 mounted on an upper peripheral edge portion 66 of the cathode 56 and extending around the layer of target titles 58.

The ground shield 64 consists of an electrically conductive material and is box-like in that it comprises a bottom wall 68 and sidewalls 70 all together defining a cavity 72 which is open at the top 73. The interior of the cavity 72 is larger than the exterior of the cathode 56 such that, when the cathode is placed into the cavity and is supported therein, e.g. by means of insulative blocks 74 on the bottom wall 68 of the ground shield 64, the cathode 56 is separated from the ground shield by a gap 76 defined between the cathode 56 and the bottom and sidewalls 68,70 of the ground shield 64. The ground shield 64, with the cathode 56 thus disposed therein, encloses the latter on all sides 78 thereof and at the bottom 80 but, at its open top 73, leaves the layer of target tiles 58 exposed. In other words, all surfaces of the cathode except the layer of target tiles 58 on its upper surface 60 are protected from being bombarded and sputtered by argon ions.

As seen from Figs. 7 and 8, the side walls 70 of the ground shield 64 associated with this earlier target design have upper, inwardly directed flanges 82 which extend around the cathode 56 in spaced overlying relationship with the retainer 65 thereon such that the gap 76 between the ground shield 64 and the cathode 56 is open towards and accessible from a direction directly facing the open top 73 of the ground shield 64, as indicated by an arrow A in Fig. 8. This is the direction in which flakes of zirconium diboride would fall upon the cathode 56 from a location above the targets 52,54. Since the upper flanges 82 of the ground shield 64, on the one hand, and the target tiles 58 and upper peripheral retainer 65 on the cathode 56, on the other hand, are oppositely charged, a flake falling onto the target and bridging the gap 76 so as to contact both the flange 82 and the retainer 65 and/or target tiles 58 will short-circuit the cathode and the ground shield.

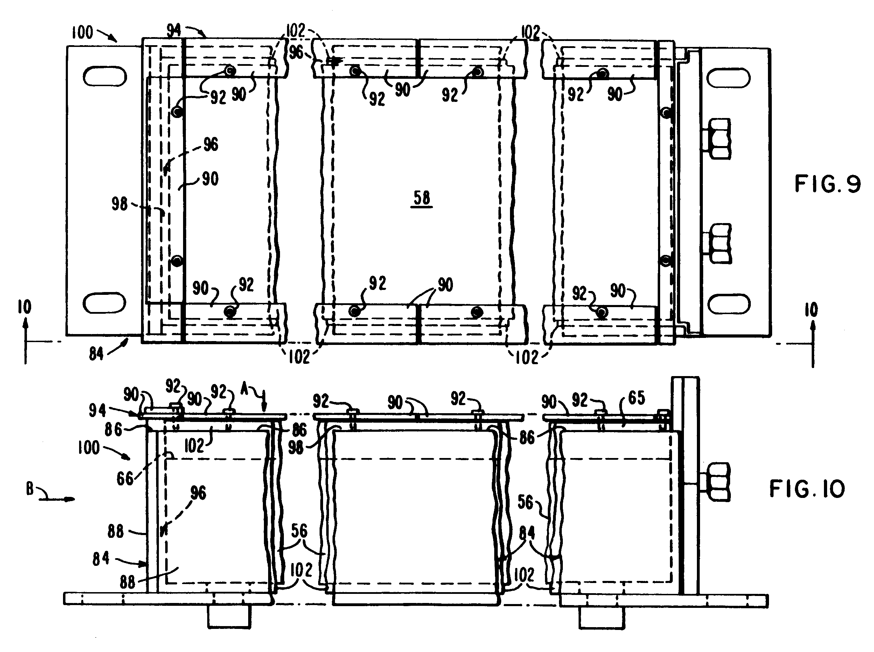

Referring now to Figs. 9 to 12, there is shown a target 100 embodying the invention. This target 100 is basically similar to the one described hereinbefore, except for the features now to be described. As seen from Figs. 9 to 12, the ground shield 84 of the target 100 differs from the ground shield 64 described above in that its sidewalls 88 are devoid of any upper lateral flanges and have their upper edges 86 displaced slightly below the upper peripheral edge of the target formed by the cathode 56 together with the target tiles 58 and the retainer 65 thereon.

In addition, the target 100 includes means in the form of peripheral strips 90 mounted on the retainer 65, hence on the peripheral edge portion 66 of the cathode surface 60, and forming a continuous peripheral ledge 94 which extends laterally outward beyond the edge portion 66 of the cathode surface so as to overhang the gap 96 and the upper edges 86 of the sidewalls 88 of the ground shield 84 in spaced relationship therewith. The strips 90 are shown connected to the retainer 65 by means of fasteners 92. Thus, the ledge 94 protects the gap 96 against exposure from the direction A directly facing the open top 98 of the ground shield 84, and in effect relocates its entrance to the sides of the target 100 for exposure from direction B (Fig. 10) facing the sidewalls 88 of the ground shield 84. Thus, any falling flakes of zirconium diboride cannot bridge the gap 96 between ground shield 84 and the cathode 56 (or the strips 90 which are electrically conductive and of the same polarity as the cathode) since this gap opens toward the lateral sides of the target 100.

In accordance with the invention, the gap 96 between the cathode 56 and the ground shield 84 is filled completely with electrical insulating material 102 for preventing dielectric breakdown and electrical arcing across the gap even under conditions of high relative humidity in the ambient surrounding the target. The insulating material 102, which fills the gap 96 so completely as to leave no perceptible space, preferably is ceramic insulation composed of aluminum oxide, although other suitable ceramic insulation, such as aluminum silicate and pyrex, may also be used.

## Claims

1. A sputter-coating-apparatus target comprising a cathode having an outer surface (66) with sputter target material disposed thereon, and a ground shield associated with the cathode and so disposed in spaced relationship with respect thereto as to define therebetween a gap which separates the cathode and the ground shield from one another, characterized in that:
said gap (96) is completely filled with an electrical insulating material (102); and
said cathode has mounted on a peripheral edge portion (66) of said outer surface (60) thereof means (90) forming a continuous peripheral ledge (94) which extends outwardly beyond said peripheral edge portion (66) and overhangs said gap (96) and the adjacent edges (86) of the ground shield (84) in spaced relationship therewith.

2. A sputter-coating-apparatus target according to claim 1, characterized in that said insulating material (102) is ceramic insulation.

3. A sputter-coating-apparatus target according to claim 2, characterized in that said ceramic insulation comprises aluminum oxide.

4. A sputter-coating-apparatus target according to claim 1, characterized in that the means (90) forming said ledge (94) comprises an arrangement of strips extending peripherally about said outer surface (60) of the cathode (56) above said peripheral edge portion (66) thereof.

5. A sputter-coating-apparatus target according to claim 4, characterized in that said sputter target material (58) has associated therewith a retainer (65) which surrounds the sputter target material and is supported on said peripheral edge portion (66) of said outer surface (60) of the cathode (56), said strips (90) being fastened to said retainer (65).

## Patentansprüche

1. Target für eine Zerstäubungsbeschichtungseinrichtung, mit einer Katode, die eine Außenfläche (66) mit darauf aufgebrachtem Zerstäubungstargetmaterial aufweist, und mit einer Masseabschirmung, die der Katode zugeordnet und relativ dazu mit Abstand so angeordnet ist, daß dazwischen ein Spalt gebildet ist, der die Katode und die Masseabschirmung voneinander trennen, dadurch gekennzeichnet, daß:
der Spalt (96) vollständig mit einem elektrisch isolierenden Material (102) ausgefüllt ist, und
die Katode auf einem peripheren Randbereich (66) der Außenfläche (60) daran montierte Mittel (90) aufweist, die eine kontinuierliche umfangsmäßige Leiste (94) bilden, die auswärts über den umfangsmäßigen Randbereich (66) übersteht und den Spalt (96) und die benachbarten Ränder (86) der Masseabschirmung (84) mit Abstand hierzu überdeckt.

2. Zerstäubungsbeschichtungseinrichtungs-Target nach Anspruch 1, dadurch gekennzeichnet, daß das isolierende Material (102) eine keramische Isolierung ist.

3. Zerstäubungsbeschichtungseinrichtungs-Target nach Anspruch 2, dadurch gekennzeichnet, daß die keramische Isolierung Aluminiumoxid aufweist.

4. Zerstäubungsbeschichtungseinrichtungs-Target nach Anspruch 1, dadurch gekennzeichnet, daß die die Leiste (94) bildenden Mittel (94) eine Anordnung aus Streifen aufweisen, die peripher um die Außenfläche (60) der Katode (56) über deren peripherem Randbereich (66) verlaufen.

5. Zerstäubungsbeschichtungseinrichtungs-Target nach Anspruch 4, dadurch gekennzeichnet, daß dem Zerstäubungstargetmaterial (58) ein Rückhalteorgan (65) zugeordnet ist, welches das Zerstäubungstargetmaterial umschließt und auf dem peripheren Randbereich (66) der Außenfläche (60) der Katode (56) gehaltert ist, und daß die Streifen (90) an den Rückhalteorgan (65) befestigt sind.

## Revendications

1. Cible d'appareil de revêtement par pulvérisation cathodique comprenant une cathode ayant une surface externe (60) sur laquelle est disposée une matière pour cible de pulvérisation cathodique, et un écran mis à la terre associé à la cathode et disposé suivant une relation d'espacement par rapport à celle-ci de manière à ce que soit défini entre eux un intervalle qui sépare la cathode et l'écran mis à la terre, caractérisée en ce que:
ledit intervalle (96) est entièrement rempli d'un matériau (102) électriquement isolant; et
sur une partie (66) formant nord périphérique de ladite surface externe (60) de ladite cathode sont montés des moyens (90) formant un rebord (94) périphérique continu qui s'étend vers l'extérieur au-delà de ladite partie (66) formant bord périphérique et qui surplombe ledit intervalle (96) et les bords adjacents (86) de l'écran mis à la terre (84) suivant une relation d'espacement par rapport à ceux-ci.

2. Cible d'appareil de revêtement par pulvérisation cathodique selon la revendication 1, caractérisée en ce que ledit matériau isolant (102) est un matériau céramique isolant.

3. Cible d'appareil de revêtement par pulvérisation cathodique selon la revendication 2, caractérisée en ce que ledit matériau céramique isolant contient de l'oxyde d'aluminium.

4. Cible d'appareil de revêtement par pulvérisation cathodique selon la revendication 1, caractérisée en ce que les moyens (90) formant ledit rebord (94) comportent un ensemble de bandes s'étendant périphériquement autour de ladite surface externe (60) de la cathode (56) au-dessus de ladite partie (66) formant bord périphérique de celle-ci.

5. Cible d'appareil de revêtement par pulvérisation cathodique selon la revendication 4, caractérisée en ce qu'à ladite matière (58) pour cible de pulvérisation cathodique est associé un moyen (65) de retenue qui entoure la matière pour cible de pulvérisation cathodique et qui est supporté sur ladite partie (66) formant bord périphérique de ladite surface externe (60) de la cathode (56), lesdites bandes (90) étant assujetties audit dispositif de retenue (65).
